# EUROPEAN PATENT SPECIFICATION

(11) **EP 4 462 140 B1**
(45) Date of publication and mention of the grant of the patent: **04.03.2026**
(21) Application number: 23824232.5
(22) Date of filing: 14.06.2023
(51) Int. Cl.: G01R 31/367, G01R 31/36, G01R 31/389, G01R 31/392, G01R 31/374, G01R 17/02

(54) **BATTERY PARAMETER ESTIMATING APPARATUS AND METHOD**
VORRICHTUNG UND VERFAHREN ZUR SCHÄTZUNG VON BATTERIEPARAMETERN
APPAREIL ET PROCÉDÉ POUR ESTIMER DES PARAMÈTRES D'UNE BATTERIE

(30) Priority: 14.06.2022 KR 20220072101
(43) Date of publication of application: 13.11.2024
(73) Proprietor: LG Energy Solution, Ltd., Seoul 07335 (KR)
(72) Inventor: YOO, Sol-Ji, Daejeon 34122 (KR); SONG, Hyeon-Jin, Daejeon 34122 (KR); KIM, Ki-Hyun, Daejeon 34122 (KR)
(74) Representative: Goddar, Heinz J.
(86) International application number: PCT/KR2023/008210
(87) International publication number: WO 2023/244019

(56) References cited:
- KR-A- 20140 066 361
- KR-A- 20170 052 835
- KR-A- 20220 043 070
- KR-A- 20220 054 127
- KR-A- 20220 058 250
- US-A1- 2017 219 660
- US-A1- 2021 382 114
- TOLOUEI NADIA E ET AL: "Development of circuit models for electrochemical impedance spectroscopy (EIS) responses of interdigitated MEMS biochemical sensors", JOURNAL OF ELECTROANALYTICAL CHEMISTRY, ELSEVIER, AMSTERDAM, NL, vol. 878, 26 August 2020 (2020-08-26), XP086362922, ISSN: 1572-6657, [retrieved on 20200826], DOI: 10.1016/J.JELECHEM.2020.114598

## Description

### TECHNICAL FIELD

The present disclosure relates to a battery parameter estimating apparatus and method, and more particularly, to a battery parameter estimating apparatus and method capable of estimating a parameter of a battery through electrochemical impedance spectroscopy (EIS).

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

In general, among various battery parameters, Ro (Ohmic resistance), Rct (Charge transfer resistance), and Cdl (double layer capacitance) can be estimated through the equivalent circuit model (ECM) and EIS. Here, Ro is the Ohm resistance value of the battery, and Rct is the charge transfer resistance value of the battery. Also, Cdl is the capacitance value of the capacitor included in the equivalent circuit model, and may be a double layer capacitance value required for a double layer to separate charges from the electrode.

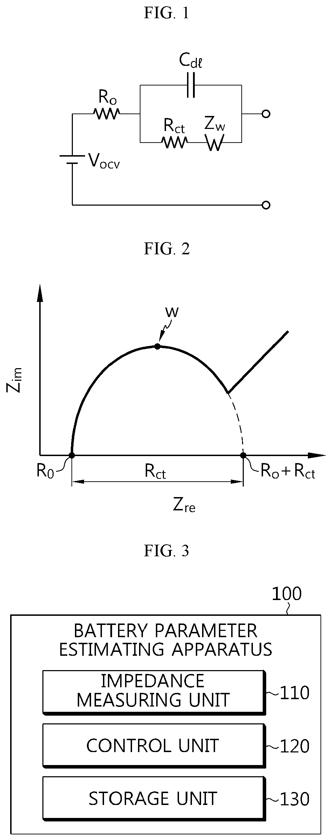

FIG. 1 is a diagram schematically showing an equivalent circuit model of a battery. FIG. 2 is a diagram schematically showing the Nyquist plot obtained through EIS.

Here, the Nyquist plot is obtained by curve-fitting the plurality of data measured through EIS, and can be divided into a real part (Zre) and an imaginary part (Zim). Ro can be calculated using the real part of the value with the highest frequency. Rct can be calculated using Arc and Ro derived through curve fitting. Cdl can be calculated based on the angular frequency and Rct at the point where the imaginary part of the arc is the largest. For example, in FIG. 2, Cdl can be calculated according to the formula "1 ÷ (w × Rct)".

However, battery parameters estimated through the Nyquist plot may include noise during the measurement process and/or calculation process. Non-patent literature discloses a method of calculating the error between the value measured through EIS and the curve fitting value using the Lin-KK (linear Kramers Kronig) method.

Battery parameters estimated through EIS can be used to estimate the internal resistance of the battery, and this internal resistance can be used to estimate the SOH (state of health) of the battery. Therefore, there is a need to develop technology that can estimate battery parameters more accurately.

US 2017/219660 A1 discloses a method of determining the State of Health (SoH) and/or State of Charge (SoC) of a rechargeable battery during use of said battery, comprising generating a first excitation signal within a first selected frequency range, generating a second excitation signal within a second selected frequency range, applying said first and second excitation signals on said rechargeable battery, measuring the response signal for each of said two excitation signals, and then calculate the Electrochemical Impedance (EI) as the ratio between the excitation signals and respective response signals, and then determine the SoH and/or SoC of the rechargeable battery by comparing the calculated EI to a circuit model for the battery and/or determining the SoH and/or SoC of the rechargeable battery by directly evaluating characteristics of the EI.

US 2021/382114 A1 discloses a battery diagnosis apparatus and a battery diagnosis method for accurately diagnosing a secondary battery using a pulse current generator, a voltage measuring instrument that measures a voltage response to application of a current pulse, a first data processing device that obtains a chronopotentiogram (CP) indicating a change in the voltage response over time and normalizes the CP, a database that saves normalized data, and a second data processing device that uses a correlation between the saved data and a battery state expressing factor prepared in advance to make a battery diagnosis.

(Non-patent literature) A Method for Improving the Robustness of linear Kramers-Kronig Validity Tests, Electrochimica Acta, 2014

Tolouei N E et Al. : "Development of circuit models for electrochemical impedance spectroscopy (EIS) responses of interdigitated MEMS biochemical sensors", J. of Elecroanalytical Chemistry, Vol 878.

### DISCLOSURE

### Technical Problem

The present disclosure is designed to solve the problems of the related art, and therefore the present disclosure is directed to providing a battery parameter estimating apparatus and method that may more accurately estimate a battery parameter.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery parameter estimating apparatus according to one aspect of the present disclosure may comprise an impedance measuring unit configured to output a plurality of AC currents to a battery and measure a plurality of impedance values for the battery to correspond to the plurality of AC currents; and a control unit configured to generate a first profile by fitting the plurality of impedance values expressed in the complex plane with a real part as a first axis and an imaginary part as a second axis, correct the plurality of impedance values based on the first profile, determine a plurality of criterion values based on the plurality of impedance correction values, generate a second profile by fitting the determined plurality of criterion values, compare the plurality of impedance correction values with the second profile, and determine whether or not to set a battery parameter according to the comparison result.

The control unit is configured to calculate a first error ratio between each of the plurality of impedance values and the first profile, compare the calculated plurality of first error ratios with a preset first threshold value, and correct the plurality of impedance values based on the comparison result.

The control unit may be configured to delete an impedance value whose corresponding first error ratio is greater than or equal to the first threshold value among the plurality of impedance values.

The control unit is configured to calculate a second error ratio between the plurality of impedance correction values and the second profile and compare the calculated second error ratio with a preset second threshold value.

The control unit may be configured to set the plurality of criterion values as the battery parameter when the second error ratio is less than the second threshold value.

When the second error ratio is greater than or equal to the second threshold value, the control unit may be configured to regenerate the first profile by fitting the plurality of impedance correction values and determine whether or not to set the battery parameter based on the regenerated first profile and the plurality of impedance correction values.

The control unit may be configured to regenerate the first profile until the second error ratio becomes less than the second threshold value.

The control unit may be configured to calculate an error ratio of each of the plurality of impedance correction values and the second profile and calculate an average of the calculated plurality of error ratios as the second error ratio.

The control unit may be configured to determine an Ohm resistance value, a charge transfer resistance value, and a double layer capacitance value of the battery as the plurality of criterion values based on the plurality of impedance correction values.

A battery pack according to another aspect of the present disclosure may comprise the battery parameter estimating apparatus according to an aspect of the present disclosure.

A battery parameter estimating method according to still another aspect of the present disclosure may comprise: an impedance value measuring step of outputting a plurality of AC currents to a battery and measuring a plurality of impedance values for the battery to correspond to the plurality of AC currents; a first profile generating step of generating a first profile by fitting the plurality of impedance values; an impedance value correcting step of correcting the plurality of impedance values based on the first profile; a criterion value determining step of determining a plurality of criterion values based on the plurality of impedance correction values; a second profile generating step of generating a second profile by fitting the determined plurality of criterion values; an impedance correction value and second profile comparing step of comparing the plurality of impedance correction values with the second profile; and a battery parameter setting determining step of determining whether or not to set a battery parameter according to the comparison result.

### Advantageous Effects

According to one aspect of the present disclosure, there is an advantage that battery parameters can be estimated with high accuracy and reliability by going through primary and secondary verification. Furthermore, there is an advantage that the accuracy and reliability of the estimated battery state can be improved by using the battery parameters according to the present disclosure.

The effects of the present disclosure are not limited to the above, and other effects not mentioned herein will be clearly understood by those skilled in the art from the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an equivalent circuit model of a battery.
FIG. 2 is a diagram schematically showing the Nyquist plot obtained through EIS.
FIG. 3 is a diagram schematically showing a battery parameter estimating apparatus according to an embodiment of the present disclosure.
FIG. 4 is a diagram schematically showing the plurality of impedance values according to an embodiment of the present disclosure.
FIG. 5 is a drawing schematically showing the first profile according to an embodiment of the present disclosure.
FIG. 6 is a diagram schematically showing the first error ratio between the plurality of impedance values and the first profile according to an embodiment of the present disclosure.
FIG. 7 is a diagram schematically showing the plurality of impedance correction values according to an embodiment of the present disclosure.
FIG. 8 is a diagram schematically showing the second profile according to an embodiment of the present disclosure.
FIG. 9 is a diagram schematically showing an exemplary configuration of a battery pack according to another embodiment of the present disclosure.
FIG. 10 is a diagram schematically showing a battery parameter estimating method according to still another embodiment of the present disclosure.
FIGS. 11 and 12 are diagrams showing in more detail the battery parameter estimating method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

FIG. 3 is a diagram schematically showing a battery parameter estimating apparatus 100 according to an embodiment of the present disclosure.

Here, the battery refers to one physically separable independent cell having a negative electrode terminal and a positive electrode terminal. For example, a lithium-ion battery or a lithium polymer cell may be regarded as the battery. In addition, the battery may refer to a battery module in which a plurality of cells are connected in series and/or in parallel. Hereinafter, for convenience of description, the battery will be described as meaning one independent cell.

Referring to FIG. 3, the battery parameter estimating apparatus 100 may include an impedance measuring unit 110 and a control unit 120.

The impedance measuring unit 110 may be configured to output a plurality of AC currents to the battery.

Specifically, the impedance measuring unit 110 may output a plurality of AC currents to the battery in order to measure the impedance value of the battery through the EIS method.

For example, when an impedance measurement signal is received from the control unit 120, the frequency of the AC current can be changed and the AC current can be output to the battery. That is, the plurality of AC currents output by the impedance measuring unit 110 may have different frequencies.

Additionally, the impedance measuring unit 110 may be configured to measure the plurality of impedance values for the battery to correspond to the plurality of AC currents.

Specifically, the impedance measuring unit 110 can measure the impedance value of the battery for each of the plurality of AC currents. Therefore, the impedance value measured by the impedance measuring unit 110 may be plural. In other words, when each of the plurality of AC currents is applied to the battery, the impedance value corresponding to the applied AC current can be measured.

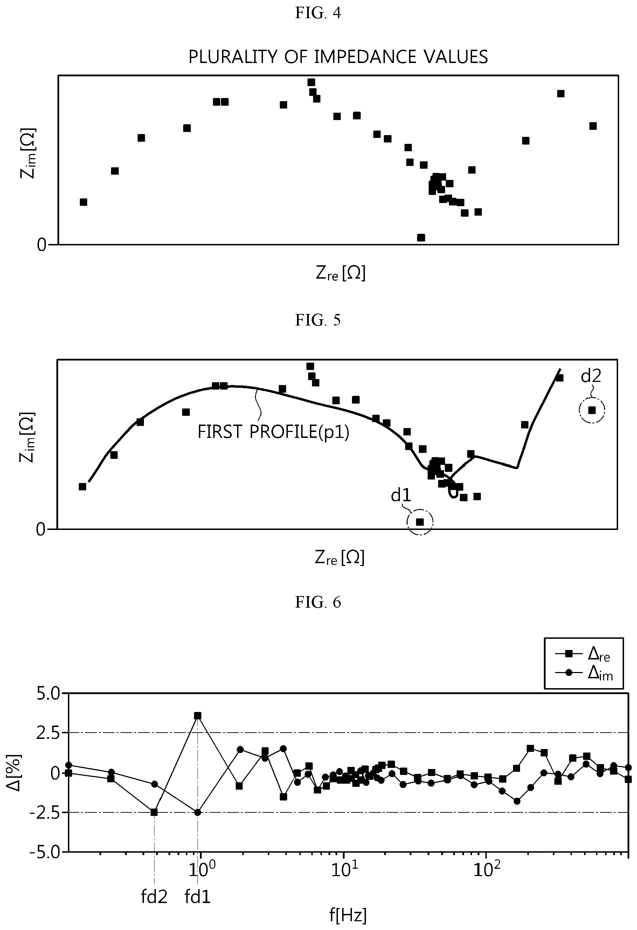

FIG. 4 is a diagram schematically showing the plurality of impedance values according to an embodiment of the present disclosure.

Referring to FIG. 4, a plurality of impedance values respectively corresponding to the plurality of AC currents can be measured. Additionally, the plurality of impedance values can be expressed in the complex plane with the real part (Zᵣₑ) as the X-axis and the imaginary part (Zᵢₘ) as the Y-axis.

The control unit 120 may be configured to generate a first profile p1 by fitting the plurality of impedance values.

Specifically, the control unit 120 may be configured to generate the first profile p1 by applying a fitting algorithm to the plurality of impedance values. Preferably, the control unit 120 can generate the first profile p1 using a curve fitting algorithm that can derive a curve or approximate function corresponding to the plurality of impedance values. For example, the control unit 120 can generate the first profile p1 corresponding to the plurality of impedance values using Lin-KK (Linear Kramers Kronig algorithm).

FIG. 5 is a drawing schematically showing the first profile p1 according to an embodiment of the present disclosure. Specifically, the first profile p1 in FIG. 5 may be an EIS profile generated by the control unit 120 for the plurality of impedance values using Lin-KK.

The control unit 120 may be configured to correct the plurality of impedance values based on the first profile p1.

While the plurality of impedance values are actual values measured by the impedance measuring unit 110, the first profile p1 may be an approximate function generated based on the plurality of impedance values. Therefore, there may be a certain degree of error between the plurality of impedance values and the first profile p1, and the control unit 120 can correct the plurality of impedance values based on this error.

First, the control unit 120 may be configured to calculate the first error ratio between each of the plurality of impedance values and the first profile p1. Specifically, the control unit 120 may determine the first reference value corresponding to each of the plurality of impedance values in the first profile p1. For example, the control unit 120 may determine the first reference value corresponding to the corresponding frequency in the first profile p1 in consideration of the frequency of each of the plurality of impedance values. That is, the corresponding impedance value and the first reference value may be values based on the same frequency.

Next, the control unit 120 can calculate the first error ratio between each of the plurality of impedance values and the corresponding first reference value. Specifically, the control unit 120 can calculate the first error ratio for each of the plurality of impedance values by calculating the ratio of the first reference value to the impedance value. For example, the control unit 120 can calculate the first error ratio for each of the plurality of impedance values by calculating the formula "(impedance value - first reference value) ÷ impedance value".

In one embodiment, the control unit 120 may calculate the first error ratio for each of the real value and the imaginary value. FIG. 6 is a diagram schematically showing the first error ratio between the plurality of impedance values and the first profile p1 according to an embodiment of the present disclosure. Specifically, FIG. 6 is a diagram showing the real error ratio (△Re) and the imaginary error ratio (△im). Here, the first error ratio may include the real error ratio (△Re) and the imaginary error ratio (△im) for the imaginary value. That is, the control unit 120 can calculate the error ratio for each of the real value and the imaginary value in order to minimize the influence of noise included in the plurality of impedance values.

Next, the control unit 120 may be configured to compare the calculated plurality of first error ratios and the preset first threshold value. Here, the first threshold value may be a preset value to correct the plurality of impedance values. For example, the first threshold value may be set to a value of 5% or less. Preferably, because the first error ratio may be calculated as a negative number, the control unit 120 can compare the magnitude of the calculated plurality of first error ratios (i.e., the absolute value of the first error ratio) and the first threshold value.

Finally, the control unit 120 may be configured to correct the plurality of impedance values based on the comparison result.

Specifically, the control unit 120 can correct the plurality of impedance values by changing or deleting an impedance value whose first error ratio is greater than or equal to the first threshold value.

For example, the control unit 120 may be configured to delete an impedance value (hereinafter referred to as a target impedance value) whose first error ratio is greater than or equal to the first threshold value among the plurality of impedance values. In other words, the control unit 120 can improve the reliability of the plurality of impedance values, which are basis data for estimating the battery parameter, by deleting impedance values that contain a lot of noise.

As another example, the control unit 120 may change the target impedance value to the corresponding first reference value. In other words, the control unit 120 can secure basic data about the corresponding frequency (frequency corresponding to the target impedance value) by changing the target impedance value without deleting it.

In the embodiments of FIGS. 5 and 6, it is assumed that the first threshold value is preset to 2.5%. The frequency corresponding to the first impedance value (d1) may be the first frequency (fd1). The control unit 120 may calculate the first error ratio (specifically, real error ratio (△Re) and imaginary error ratio (△im)) between the first impedance value (d1) and the first reference value corresponding to the first frequency (fd1) in the first profile p1. Since the calculated real error ratio (△Re) and imaginary error ratio (△im) are greater than the first threshold value, the control unit 120 can delete the first impedance value (d1).

Additionally, in the embodiments of FIGS. 5 and 6, the frequency corresponding to the second impedance value (d2) may be the second frequency (fd2). The control unit 120 may calculate the first error ratio (specifically, real error ratio (△Re) and imaginary error ratio (△im)) between the second impedance value (d2) and the first reference value corresponding to the second frequency (fd2) in the first profile p1. Since the magnitude of the calculated real error ratio (△Re) is greater than or equal to the first threshold value, the control unit 120 can delete the second impedance value (d2).

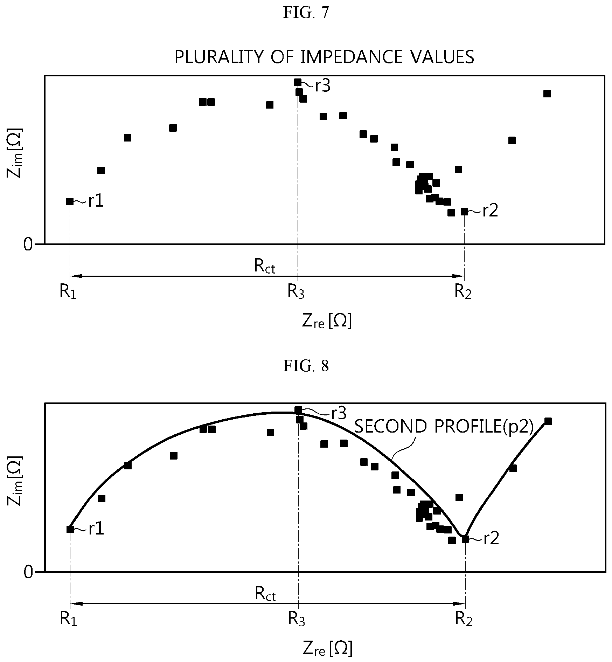

FIG. 7 is a diagram schematically showing the plurality of impedance correction values according to an embodiment of the present disclosure. If comparing FIG. 5 and FIG. 7, the first impedance value (d1) and the second impedance value (d2) can be deleted or corrected by the control unit 120.

The control unit 120 may be configured to determine the plurality of criterion values based on the plurality of impedance correction values.

Specifically, the control unit 120 may determine the parameter of the equivalent circuit model for the battery based on the plurality of impedance correction values.

For example, the control unit 120 may be configured to determine the Ohm resistance value (Ro), the charge transfer resistance value (Rct), and the double layer capacitance value (Cdl) of the battery as the plurality of criterion values based on the plurality of impedance correction values.

The control unit 120 can determine the real value of the value with the highest frequency among the plurality of impedance correction values as the Ohm resistance value (Ro). For example, in the embodiment of FIG. 7, the control unit 120 may select the first impedance correction value (r1) with the largest frequency among the plurality of impedance correction values. Additionally, the control unit 120 may determine the real value (R1) of the first impedance correction value (r1) as the Ohm resistance value (Ro).

Additionally, in the embodiment of FIG. 7, the control unit 120 may select the second impedance correction value (r2) corresponding to the frequency at which the Bode plot is minimum among the plurality of impedance correction values. Additionally, the control unit 120 may determine the charge transfer resistance value (Rct) by subtracting the real value (R1) of the first impedance correction value (r1) from the real value (R2) of the second impedance correction value (r2).

Additionally, in the embodiment of FIG. 7, the control unit 120 may select the third impedance correction value (r3) with the largest imaginary value between the first impedance correction value (r1) and the second impedance correction value (r2). The control unit 120 can calculate the double layer capacitance value (Cdl) based on the frequency (or angular frequency) corresponding to the third impedance correction value (r3) and the real value (R3) of the third impedance correction value (r3). For example, the control unit 120 can calculate the double layer capacitance value (Cdl) by calculating the formula "1 ÷ (2 × π × f3 × R3)". Here, f3 is the frequency corresponding to the third impedance correction value (r3), and "2 × π × f3" can be replaced by the angle frequency (w) for the third impedance correction value (r3).

The control unit 120 may be configured to generate a second profile p2 by fitting the determined plurality of criterion values.

Specifically, the control unit 120 may be configured to generate a second profile p2 by applying a fitting algorithm to the plurality of criterion values. Preferably, the control unit 120 can generate the second profile p2 using a curve fitting algorithm that can derive a curve or approximation function corresponding to the plurality of criterion values.

Since the first profile p1 is generated based on the plurality of impedance values and the second profile p2 is generated based on the plurality of criterion values (this includes the capacitance value rather than the impedance value), the fitting algorithms used by the control unit 120 to generate the first profile p1 and the second profile p2 may be different. For example, the control unit 120 can generate the second profile p2 corresponding to the plurality of criterion values using Curve fit of SciPy.

FIG. 8 is a diagram schematically showing the second profile p2 according to an embodiment of the present disclosure. Specifically, the second profile p2 in FIG. 8 may be an EIS profile generated by the control unit 120 for the plurality of criterion values using Curve fit of SciPy.

The control unit 120 may be configured to compare the plurality of impedance correction values and the second profile p2.

Specifically, the control unit 120 may be configured to calculate the second error ratio between the plurality of impedance correction values and the second profile p2, and compare the calculated second error ratio with a preset second threshold value.

First, the control unit 120 may be configured to calculate the error ratio between each of the plurality of impedance correction values and the second profile p2. For example, the control unit 120 may determine the second reference value corresponding to the corresponding frequency in the second profile p2 in consideration of the frequency of each of the plurality of impedance correction values. That is, the corresponding impedance correction value and the second reference value may be values based on the same frequency. Additionally, the control unit 120 can calculate the error ratio between the plurality of impedance correction values and the corresponding second reference value. Specifically, the control unit 120 can calculate the error ratio for each of the plurality of impedance correction values by calculating the ratio of the second reference value to the impedance correction value. For example, the control unit 120 may calculate the error ratio for each of the plurality of impedance correction values by calculating the formula "(impedance correction value - second reference value) ÷ impedance correction value".

Next, the control unit 120 may be configured to calculate the average of the calculated plurality of error ratios as the second error ratio. For example, the control unit 120 may calculate the average of the calculated plurality of error ratios and set the calculated average as the second error ratio. In other words, the first error ratio refers to the error ratio for each of the plurality of impedance values, but the second error ratio may refer to the average error ratio of the plurality of impedance correction values.

Finally, the control unit 120 may be configured to compare the calculated second error ratio with a preset second threshold value. Specifically, the control unit 120 can compare the magnitudes of the calculated second error ratio and the second threshold value.

The control unit 120 may be configured to determine whether or not to set a battery parameter according to the comparison result.

For example, the control unit 120 may be configured to set the plurality of criterion values as a battery parameter when the second error ratio is less than the second threshold value. Conversely, the control unit 120 may not set the battery parameter when the second error ratio is greater than or equal to the second threshold value.

In general, since the battery parameter can be a key factor in configuring an equivalent circuit model, it can be used to estimate the SOH of the battery, etc. Therefore, the accuracy and reliability of the battery parameter can have a significant impact on the battery SOH estimation.

Since the battery parameter estimating apparatus 100 according to an embodiment of the present disclosure determines the battery parameter after going through primary and secondary verification using different curve fitting algorithms, the battery parameter estimated by the battery parameter estimating apparatus 100 can have high accuracy and reliability. Furthermore, when the SOH of the battery is estimated based on the battery parameter, the accuracy and reliability of the SOH can be high.

Meanwhile, the control unit 120 included in the battery parameter estimating apparatus 100 may optionally include an application-specific integrated circuit (ASIC), another chipset, a logic circuit, a register, a communication modem, and a data processing device, and the like, known in the art to execute various control logics disclosed below. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery parameter estimating apparatus 100 may further include a storage unit 130. The storage unit 130 may store data necessary for operation and function of each component of the battery parameter estimating apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store a library for a curve fitting algorithm used by the control unit 120 in advance. The control unit 120 can generate the first profile p1 and the second profile p2 using the algorithm stored in the storage unit 130.

Hereinafter, the case where the second error ratio is greater than or equal to the second threshold value will be described in detail.

The control unit 120 may be configured to regenerate the first profile p1 by fitting the plurality of impedance correction values when the second error ratio is greater than or equal to the second threshold value.

Specifically, when the battery parameter cannot be set because the second error ratio is greater than or equal to the second threshold value, the control unit 120 may treat the plurality of impedance correction values as the plurality of impedance values. Also, the control unit 120 can regenerate the first profile p1 by applying a curve fitting algorithm to the plurality of impedance correction values.

For example, the control unit 120 can regenerate the first profile p1 by applying Lin-KK to the plurality of impedance correction values. In other words, the first profile p1 based on the plurality of impedance values and the first profile p1 based on the plurality of impedance correction values may be generated differently because the input data is different.

In the embodiment of FIG. 8, when the second error ratio between the second profile p2 and the plurality of impedance correction values is greater than or equal to the second threshold value, the control unit 120 may regenerate the first profile p1 with respect to the plurality of impedance correction values.

The control unit 120 may be configured to determine whether or not to set the battery parameter based on the regenerated first profile p1 and the plurality of impedance correction values. Preferably, the control unit 120 may be configured to regenerate the first profile p1 until the second error ratio becomes less than the second threshold value.

Specifically, the control unit 120 may compare the regenerated first profile p1 and the plurality of impedance correction values, and correct the plurality of impedance correction values again according to the comparison result. Additionally, the control unit 120 may newly determine a plurality of criterion values based on the plurality of impedance re-correction value. The control unit 120 can generate the second profile p2 according to the newly determined criterion value. Finally, the control unit 120 can compare the generated second profile p2 and the plurality of impedance re-correction values and determine whether or not to set the battery parameter according to the comparison result. If the second error ratio of the plurality of impedance re-correction values is greater than or equal to the second threshold value, the first profile p1 can be generated again based on the plurality of impedance re-correction values.

In other words, the battery parameter estimating apparatus 100 according to an embodiment of the present disclosure can repeatedly perform primary and secondary verification while updating the base data until the accuracy and reliability of the set battery parameter reach a predetermined level or higher. Accordingly, the accuracy and reliability of the battery parameter estimated by the battery parameter estimating apparatus 100 may be very high.

The battery parameter estimating apparatus 100 according to the present disclosure may be applied to a battery management system (BMS). That is, the BMS according to the present disclosure may include the battery parameter estimating apparatus 100 described above. In this configuration, at least some of components of the battery parameter estimating apparatus 100 may be implemented by supplementing or adding functions of the components included in a conventional BMS. For example, the impedance measuring unit 110, the control unit 120 and the storage unit 130 of the battery parameter estimating apparatus 100 may be implemented as components of the BMS.

In addition, the battery parameter estimating apparatus 100 according to the present disclosure may be provided to a battery pack 10. That is, the battery pack 10 according to the present disclosure may include the above-described battery parameter estimating apparatus 100 and one or more battery cells B. In addition, the battery pack 10 may further include electrical components (a relay, a fuse and the like) and a case.

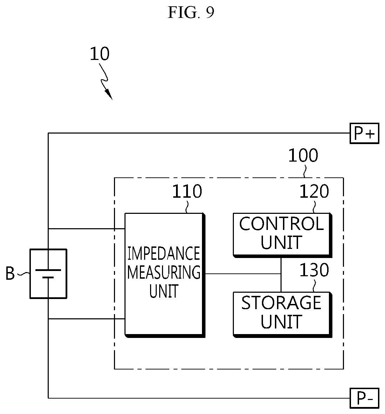

FIG. 9 is a diagram schematically showing an exemplary configuration of a battery pack 10 according to another embodiment of the present disclosure.

Referring to FIG. 9, the impedance measuring unit 110 may be connected to the positive and negative electrode terminals of the battery cell B. When the impedance measuring unit 110 receives an impedance measurement signal from the control unit 120, it can output AC current to the battery cell B. Additionally, the impedance measuring unit 110 outputs a plurality of AC currents with different frequencies to the battery cell B, and can measure the impedance of the battery cell B corresponding to each frequency. The impedance measuring unit 110 can transmit the measured plurality of impedance values to the control unit 120 and store them in the storage unit 130.

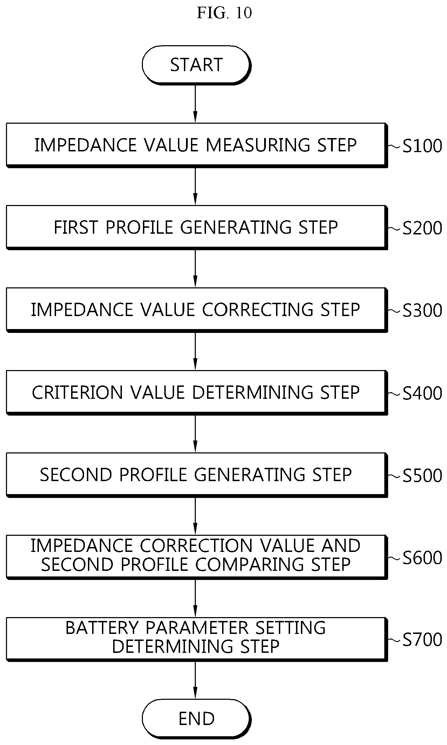

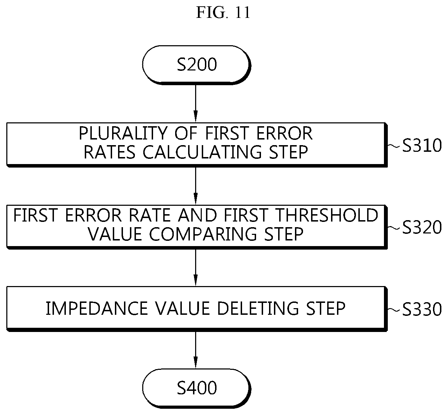

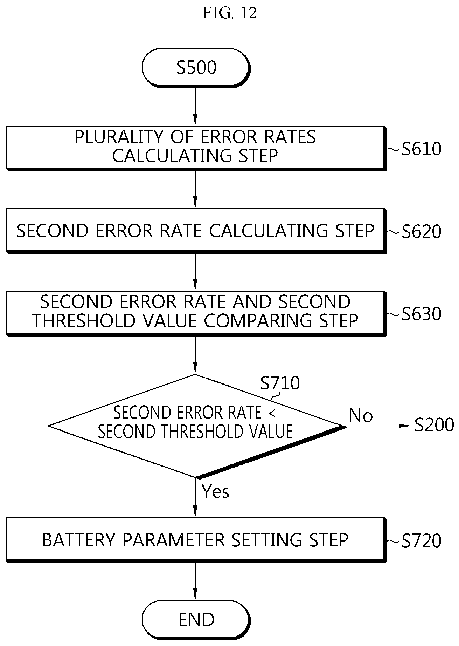

FIG. 10 is a diagram schematically showing a battery parameter estimating method according to still another embodiment of the present disclosure. FIGS. 11 and 12 are diagrams showing in more detail the battery parameter estimating method according to still another embodiment of the present disclosure.

Preferably, each step of the battery parameter estimating method may be performed by the battery parameter estimating apparatus 100. Hereinafter, for convenience of explanation, the content overlapping with the previously described content will be omitted or briefly described.

Referring to FIG. 10, the battery parameter estimating method may include an impedance value measuring step (S100), a first profile generating step (S200), an impedance value correcting step (S300), a criterion value determining step (S400), a second profile generating step (S500), an impedance correction value and second profile comparing step (S600) and a battery parameter setting determining step (S700).

The impedance value measuring step (S100) is a step of outputting a plurality of AC currents to the battery and measuring a plurality of impedance values for the battery to correspond to the plurality of AC currents, and may be performed by the impedance measuring unit 110.

For example, the impedance measuring unit 110 can output a plurality of AC currents with different frequencies to the battery and measure the impedance value corresponding to each frequency.

The first profile generating step (S200) is a step of generating the first profile p1 by fitting the plurality of impedance values, and may be performed by the control unit 120.

For example, the control unit 120 can generate the first profile p1 by fitting the plurality of impedance values using Lin-KK.

The impedance value correcting step (S300) is a step of correcting the plurality of impedance values based on the first profile p1, and may be performed by the control unit 120.

For example, the control unit 120 can calculate the first error ratio of the first profile p1 and each of the plurality of impedance values. Also, the control unit 120 can correct the plurality of impedance values according to the result of comparing the first error ratio and the preset first threshold value.

Referring to FIG. 11, the impedance value correcting step (S300) may include a plurality of first error ratios calculating step (S310), a first error ratio and first threshold value comparing step (S320), and an impedance value deleting step (S320).

The plurality of first error ratios calculating step (S310) is a step of calculating the first error ratio between each of the plurality of impedance values and the first profile p1, and may be performed by the control unit 120.

For example, the control unit 120 can calculate the first error ratio between the impedance value and the first reference value on the first profile p1 for each frequency.

The first error ratio and first threshold value comparing step (S320) is a step of comparing the plurality of first error ratios and the preset first threshold value, and may be performed by the control unit 120.

For example, the control unit 120 can compare the magnitude of the plurality of first error ratios and the magnitude of the first threshold value.

The impedance value deletion step (S320) is a step of correcting the plurality of impedance values based on the comparison result, and may be performed by the control unit 120.

For example, the control unit 120 can delete the impedance value whose first error ratio is greater than or equal to the first threshold value among the plurality of impedance values.

As another example, the control unit 120 may change the impedance value whose first error ratio is greater than or equal to the first threshold value among the plurality of impedance values to the corresponding first reference value. That is, the original impedance value is deleted, and the plurality of impedance values may include the first reference value.

The criterion value determining step (S400) is a step of determining the plurality of criterion values based on the plurality of impedance correction values, and may be performed by the control unit 120.

For example, the control unit 120 may determine the Ohm resistance value (Ro), the charge transfer resistance value (Rct), and the double layer capacitance value (Cdl) of the battery as the plurality of criterion values based on the plurality of impedance correction values.

The second profile generating step (S500) is a step of generating a second profile p2 by fitting the determined plurality of criterion values, and may be performed by the control unit 120.

For example, the control unit 120 can generate a second profile p2 corresponding to the plurality of criterion values by using Curve fit of SciPy.

The impedance correction value and second profile comparing step (S600) is a step of comparing the plurality of impedance correction values and the second profile p2, and may be performed by the control unit 120.

The battery parameter setting determining step (S700) is a step of determining whether or not to set a battery parameter according to the comparison result, and may be performed by the control unit 120.

For example, the control unit 120 can calculate the second error ratio of the second profile p2 and the plurality of impedance correction values. Also, the control unit 120 can determine whether or not to set the battery parameter according to the result of comparing the second error ratio and the preset second threshold value.

Referring to FIG. 12, the impedance correction value and second profile comparing step (S600) may include a plurality of error ratios calculating step (S610), a second error ratio calculating step (S620), and a second error ratio and second threshold value comparing step (S630). The battery parameter setting determining step (S700) may include a comparing step (S710) and a battery parameter setting step (S720).

The plurality of error ratios calculating step (S610) is a step of calculating the error ratio of each of the plurality of impedance correction values and the second profile p2, and may be performed by the control unit 120.

For example, the control unit 120 may calculate the error ratio for the plurality of impedance correction values by comparing each of the plurality of impedance correction values with the second reference value on the second profile p2.

The second error ratio calculating step (S620) is a step of calculating the average of the calculated plurality of error ratios as the second error ratio, and may be performed by the control unit 120.

For example, the control unit 120 may calculate the second error ratio by calculating the average of the plurality of error ratios calculated in the plurality of error ratios calculating step (S610).

The second error ratio and second threshold value comparing step (S630) is a step of comparing the calculated second error ratio and the preset second threshold value, and may be performed by the control unit 120.

For example, the control unit 120 can compare the magnitude of the second error ratio and the magnitude of the second threshold value.

The comparing step (S710) is a step of comparing the magnitudes of the second error ratio and the second threshold value, and may be performed by the control unit 120.

For example, if the result of the comparing step (S710) is Yes, the battery parameter setting step (S720) may be performed, and if the result of the comparing step (S710) is No, the first profile generating step (S200) may be performed. That is, if the second error ratio is greater than or equal to the second threshold value, the first profile p1 can be regenerated based on the plurality of impedance correction values.

The battery parameter setting step (S720) is a step of setting the plurality of criterion values as the battery parameter, and may be performed by the control unit 120.

For example, the control unit 120 can set the Ohm resistance value (Ro), the charge transfer resistance value (Rct), and the double layer capacitance value (Cdl) as the battery parameter.

The embodiments of the present disclosure described above may not be implemented only through an apparatus and method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

The present invention is defined by the appended claims.

### (Explanation of reference signs)

10: battery pack
100: battery parameter estimating apparatus
110: impedance measuring unit
120: control unit
130: storage unit

## Claims

1. A battery parameter estimating apparatus (100), comprising:
an impedance measuring unit (110) configured to output a plurality of AC currents to a battery and measure a plurality of impedance values for the battery to correspond to the plurality of AC currents; and
a control unit (120) configured to generate a first profile by fitting the plurality of impedance values expressed in the complex plane with a real part (Zre) as a first axis and an imaginary part (Zim) as a second axis, correct the plurality of impedance values based on the first profile, wherein the control unit (120) is configured to calculate a first error ratio between each of the plurality of impedance values and the first profile, compare the calculated plurality of first error ratios with a preset first threshold value, and correct the plurality of impedance values based on the comparison result, and determine a plurality of criterion values based on the plurality of impedance correction values, generate a second profile by fitting the determined plurality of criterion values, compare the plurality of impedance correction values with the second profile, wherein the control unit (120) is configured to calculate a second error ratio between the plurality of impedance correction values and the second profile and compare the calculated second error ratio with a preset second threshold value, and determine whether or not to set a battery parameter according to the comparison result.

2. The battery parameter estimating apparatus (100) according to claim 1,
wherein the control unit (120) is configured to delete an impedance value whose corresponding first error ratio is greater than or equal to the first threshold value among the plurality of impedance values.

3. The battery parameter estimating apparatus (100) according to claim 1 or 2,
wherein the control unit (120) is configured to set the plurality of criterion values as the battery parameter when the second error ratio is less than the second threshold value.

4. The battery parameter estimating apparatus (100) according to any one of claims 1-3,
wherein when the second error ratio is greater than or equal to the second threshold value, the control unit (120) is configured to regenerate the first profile by fitting the plurality of impedance correction values and determine whether or not to set the battery parameter based on the regenerated first profile and the plurality of impedance correction values.

5. The battery parameter estimating apparatus (100) according to claim 4,
wherein the control unit (120) is configured to regenerate the first profile until the second error ratio becomes less than the second threshold value.

6. The battery parameter estimating apparatus (100) according to any one of claims 1-5,
wherein the control unit (120) is configured to calculate an error ratio of each of the plurality of impedance correction values and the second profile and calculate an average of the calculated plurality of error ratios as the second error ratio.

7. The battery parameter estimating apparatus (100) according to any one of claims 1-6,
wherein the control unit (120) is configured to determine an Ohm resistance value, a charge transfer resistance value, and a double layer capacitance value of the battery as the plurality of criterion values based on the plurality of impedance correction values.

8. A battery pack (10), comprising the battery parameter estimating apparatus (100) according to any one of claims 1 to 7.

9. A battery parameter estimating method, comprising:
an impedance value measuring step of outputting a plurality of AC currents to a battery and measuring a plurality of impedance values for the battery to correspond to the plurality of AC currents;
a first profile generating step of generating a first profile by fitting the plurality of impedance values expressed in the complex plane with a real part (Zre) as a first axis and an imaginary part (Zim) as a second axis;
an impedance value correcting step of correcting the plurality of impedance values based on the first profile, comprising calculating a first error ratio between each of the plurality of impedance values and the first profile, comparing the calculated plurality of first error ratios with a preset first threshold value, and correcting the plurality of impedance values based on the comparison result; and
a criterion value determining step of determining a plurality of criterion values based on the plurality of impedance correction values;
a second profile generating step of generating a second profile by fitting the determined plurality of criterion values;
an impedance correction value and second profile comparing step of comparing the plurality of impedance correction values with the second profile, comprising calculating a second error ratio between the plurality of impedance correction values and the second profile and comparing the calculated second error ratio with a preset second threshold value; and
a battery parameter setting determining step of determining whether or not to set a battery parameter according to the comparison result.

## Patentansprüche

1. Batterieparameterschätzvorrichtung (100), umfassend:
eine Impedanzmesseinheit (110), die eingrichtet ist, eine Vielzahl von Wechselstromströmen an eine Batterie auszugeben und eine Vielzahl von Impedanzwerten für die Batterie zu messen, die der Vielzahl von Wechselstromströmen entsprechen sollen; und
eine Steuereinheit (120), die eingerichtet ist, ein erstes Profil durch Fitten der Vielzahl von Impedanzwerten, die in der komplexen Ebene ausgedrückt sind, mit einem Realteil (Zre) als eine erste Achse und einem Imaginärteil (Zim) als eine zweite Achse zu erzeugen, die Vielzahl von Impedanzwerten basierend auf dem ersten Profil zu korrigieren, wobei die Steuereinheit (120) eingerichtet ist, ein erstes Fehlerverhältnis zwischen jedem der Vielzahl von Impedanzwerten und dem ersten Profil zu berechnen, die berechnete Vielzahl von ersten Fehlerverhältnissen mit einem voreingestellten ersten Schwellenwert zu vergleichen und die Vielzahl von Impedanzwerten basierend auf dem Vergleichsergebnis zu korrigieren und eine Vielzahl von Kriteriumswerten basierend auf der Vielzahl von Impedanzkorrekturwerten zu bestimmen, ein zweites Profil durch Fitten der bestimmten Vielzahl von Kriteriumswerten zu erzeugen, die Vielzahl von Impedanzkorrekturwerten mit dem zweiten Profil zu vergleichen, wobei die Steuereinheit (120) eingerichtet ist, ein zweites Fehlerverhältnis zwischen der Vielzahl von Impedanzkorrekturwerten und dem zweiten Profil zu berechnen und das berechnete zweite Fehlerverhältnis mit einem voreingestellten zweiten Schwellenwert zu vergleichen und zu bestimmen, ob ein Batterieparameter gemäß dem Vergleichsergebnis einzustellen ist oder nicht.

2. Batterieparameterschätzvorrichtung (100) nach Anspruch 1,
wobei die Steuereinheit (120) eingerichtet ist, einen Impedanzwert, dessen entsprechendes erstes Fehlerverhältnis größer oder gleich dem ersten Schwellenwert ist, aus der Vielzahl von Impedanzwerten zu löschen.

3. Batterieparameterschätzvorrichtung (100) nach Anspruch 1 oder 2,
wobei die Steuereinheit (120) eingerichtet ist, die Vielzahl von Kriteriumswerten als den Batterieparameter einzustellen, wenn das zweite Fehlerverhältnis kleiner als der zweite Schwellenwert ist.

4. Batterieparameterschätzvorrichtung (100) nach einem der Ansprüche 1-3,
wobei, wenn das zweite Fehlerverhältnis größer oder gleich dem zweiten Schwellenwert ist, die Steuereinheit (120) eingerichtet ist, das erste Profil durch Fitten der Vielzahl von Impedanzkorrekturwerten zu regenerieren und zu bestimmen, ob der Batterieparameter basierend auf dem regenerierten ersten Profil und der Vielzahl von Impedanzkorrekturwerten einzustellen ist oder nicht.

5. Batterieparameterschätzvorrichtung (100) nach Anspruch 4,
wobei die Steuereinheit (120) eingerichtet ist, das erste Profil zu regenerieren, bis das zweite Fehlerverhältnis kleiner als der zweite Schwellenwert wird.

6. Batterieparameterschätzvorrichtung (100) nach einem der Ansprüche 1-5,
wobei die Steuereinheit (120) eingerichtet ist, ein Fehlerverhältnis jedes der Vielzahl von Impedanzkorrekturwerten und des zweiten Profils zu berechnen und einen Mittelwert der berechneten Vielzahl von Fehlerverhältnissen als das zweite Fehlerverhältnis zu berechnen.

7. Batterieparameterschätzvorrichtung (100) nach einem der Ansprüche 1-6,
wobei die Steuereinheit (120) eingerichtet ist, einen ohmschen Widerstandswert, einen Ladungstransferwiderstandswert und einen Doppelschichtkapazitätswert der Batterie als die Vielzahl von Kriteriumswerten basierend auf der Vielzahl von Impedanzkorrekturwerten zu bestimmen.

8. Batteriepack (10), umfassend die Batterieparameterschätzvorrichtung (100) nach einem der Ansprüche 1 bis 7.

9. Batterieparameterschätzverfahren, umfassend:
einen Impedanzwertmessschritt des Ausgebens einer Vielzahl von Wechselstromströmen an eine Batterie und des Messens einer Vielzahl von Impedanzwerten für die Batterie, die der Vielzahl von Wechselstromströmen entsprechen sollen;
einen ersten Profilerzeugungsschritt des Erzeugens eines ersten Profils durch Fitten der Vielzahl von Impedanzwerten, die in der komplexen Ebene ausgedrückt sind, mit einem Realteil (Zre) als eine erste Achse und einem Imaginärteil (Zim) als eine zweite Achse;
einen Impedanzwertkorrekturschritt des Korrigierens der Vielzahl von Impedanzwerten basierend auf dem ersten Profil, umfassend das Berechnen eines ersten Fehlerverhältnisses zwischen jedem der Vielzahl von Impedanzwerten und dem ersten Profil, das Vergleichen der berechneten Vielzahl von ersten Fehlerverhältnissen mit einem voreingestellten ersten Schwellenwert und das Korrigieren der Vielzahl von Impedanzwerten basierend auf dem Vergleichsergebnis; und
einen Kriteriumswertbestimmungsschritt des Bestimmens einer Vielzahl von Kriteriumswerten basierend auf der Vielzahl von Impedanzkorrekturwerten;
einen zweiten Profilerzeugungsschritt des Erzeugens eines zweiten Profils durch Fitten der bestimmten Vielzahl von Kriteriumswerten;
einen Impedanzkorrekturwert- und zweiten Profilvergleichsschritt des Vergleichens der Vielzahl von Impedanzkorrekturwerten mit dem zweiten Profil, umfassend das Berechnen eines zweiten Fehlerverhältnisses zwischen der Vielzahl von Impedanzkorrekturwerten und dem zweiten Profil und das Vergleichen des berechneten zweiten Fehlerverhältnisses mit einem voreingestellten zweiten Schwellenwert; und
einen Batterieparametereinstellungsbestimmungsschritt des Bestimmens, ob ein Batterieparameter gemäß dem Vergleichsergebnis einzustellen ist oder nicht.

## Revendications

1. Appareil d'estimation de paramètre de batterie (100), comprenant :
un dispositif de mesure de l'impédance (110) configuré pour fournir une pluralité de courants c.a. à une batterie, et mesurer une pluralité de valeurs d'impédance pour la batterie afin qu'elles correspondent à la pluralité de courants c.a. ; et
un module de commande (120) configuré pour générer un premier profil en intégrant la pluralité de valeurs d'impédance exprimées dans le plan complexe, avec une valeur réelle (Zre) en tant que premier axe, et une partie imaginaire (Zim) en tant que deuxième axe, rectifier la pluralité de valeurs d'impédance en fonction du premier profil, le module de commande (120) étant configuré pour calculer un premier taux d'erreur entre chacune de la pluralité de valeurs d'impédance et le premier profil, comparer la pluralité calculée de premiers taux d'erreur avec une première valeur seuil préétablie, et rectifier la pluralité de valeurs d'impédance en fonction du résultat de la comparaison, et déterminer une pluralité de valeurs critères en fonction de la pluralité de valeurs de rectification d'impédance, générer un deuxième profil en intégrant la pluralité établie de valeurs critère, comparer la pluralité de valeurs de rectification d'impédance avec le deuxième profil, le module de commande (120) étant configuré pour calculer un deuxième taux d'erreur entre la pluralité de valeurs de rectification d'impédance et le deuxième profil, et comparer le deuxième taux d'erreur calculé avec une deuxième valeur seuil préétablie, et déterminer si oui ou non l'on doit établir un paramètre de batterie en fonction du résultat de la comparaison.

2. Appareil d'estimation de paramètre de batterie (100) selon la revendication 1,
le module de commande (120) étant configuré pour supprimer une valeur d'impédance dont le premier taux d'erreur correspondant est supérieur ou égal à la première valeur seuil parmi la pluralité de valeurs d'impédance.

3. Appareil d'estimation de paramètre de batterie (100) selon la revendication 1 ou 2,
le module de commande (120) étant configuré pour établir la pluralité de valeurs critère en tant que paramètre de batterie lorsque le deuxième taux d'erreur est inférieur à la deuxième valeur seuil.

4. Appareil d'estimation de paramètre de batterie (100) selon une quelconque des revendications 1 à 3,
dans lequel, lorsque le deuxième taux d'erreur est supérieur ou égal à la deuxième valeur seuil, le module de commande (120) est configuré pour régénérer le premier profil en intégrant la pluralité de valeurs de rectification d'impédance, et déterminer si oui ou non l'on doit établir le paramètre de batterie d'après le premier profil régénéré et la pluralité de valeurs de rectification d'impédance.

5. Appareil d'estimation de paramètre de batterie (100) selon la revendication 4,
le module de commande (120) étant configuré pour régénérer le premier profil jusqu'à ce que le deuxième taux d'erreur devienne inférieur à la deuxième valeur seuil.

6. Appareil d'estimation de paramètre de batterie (100) selon une quelconque des revendications 1 à 5,
le module de commande (120) étant configuré pour calculer un taux d'erreur de chacune de la pluralité de valeurs de rectification d'impédance et du deuxième profil, et calculer une moyenne de la pluralité calculée de taux d'erreur en tant que deuxième taux d'erreur.

7. Appareil d'estimation de paramètre de batterie (100) selon une quelconque des revendications 1 à 6,
le module de commande (120) étant configuré pour établir une valeur de résistance ohmique, une valeur de résistance de transfert de charge, et une valeur de capacité double couche de la batterie en tant que pluralité de valeurs critère d'après la pluralité de valeurs de rectification d'impédance.

8. Bloc-batterie (10) comprenant l'appareil d'estimation de paramètre de batterie (100) selon une quelconque des revendications 1 à 7.

9. Procédé d'estimation de paramètre de batterie comprenant :
une étape de mesure de la valeur de l'impédance comportant la fourniture d'une pluralité de courants c.a. à une batterie, et de mesure d'une pluralité de valeurs d'impédance pour la batterie afin qu'elles correspondent à la pluralité de courants c.a. ;
une étape de génération d'un premier profil en dotant la pluralité de valeurs d'impédance exprimées dans le plan complexe d'une partie réelle (Zre) en tant que premier axe, et d'une partie imaginaire (Zim) en tant que deuxième axe ;
une étape de rectification de la valeur d'impédance, comportant la rectification de la pluralité de valeurs d'impédance d'après le premier profil, comprenant le calcul d'un premier taux d'erreur entre chacune de la pluralité de valeurs d'impédance et le premier profil, la comparaison de la pluralité calculée de premiers taux d'erreur avec une première valeur seuil préétablie, et la rectification de la pluralité de valeurs d'impédance en fonction du résultat de la comparaison ; et
une étape de détermination d'une valeur critère comportant la détermination d'une pluralité de valeurs critères en fonction de la pluralité de valeurs de rectification d'impédance ;
une étape de génération d'un deuxième profil, comportant la génération d'un deuxième profil en intégrant la pluralité établie de valeurs critère ;
une étape de comparaison de la valeur de rectification d'impédance et du deuxième profil, comportant une comparaison de la pluralité de valeurs de rectification d'impédance avec le deuxième profil, comportant le calcul d'un deuxième taux d'erreur entre la pluralité de valeurs de rectification d'impédance et le deuxième profil, et la comparaison entre le deuxième taux d'erreur calculé et une deuxième valeur seuil préétablie ;
et
une étape de détermination de l'établissement d'un paramètre de batterie afin de déterminer si l'on doit, ou non, établir un paramètre de batterie en fonction du résultat de la comparaison.
